# EUROPEAN PATENT SPECIFICATION

(11) **EP 1 943 535 B1**
(45) Date of publication and mention of the grant of the patent: **02.03.2011**
(21) Application number: 06803494.1
(22) Date of filing: 13.09.2006
(51) Int. Cl.: G01R 33/28, A61B 5/055

(54) **MRI CATHETER COMPRISING MEANS FOR SUPPRESSING RESONANT RF HEATING**
MRI-KATHETER MIT MITTELN ZUR UNTERDRÜCKUNG VON RESONANZ-HF-ERWÄRMUNG
CATHETER IRM DOTE D'UN DISPOSITIF DE SUPPRESSION DE CHAUFFAGE RESONANT RF

(30) Priority: 14.09.2005 US 716503 P
(43) Date of publication of application: 16.07.2008
(60) Divisional application: 10187731.4
(73) Proprietor: The Government of the United States of America as represented by The Secretary of the Department of Health and Human Services, Rockville, MD 20852-3804 (US)
(72) Inventor: KOCATURK, Ozgur, Rockville, MD 20850 (US)
(74) Representative: Wright, Howard Hugh Burnby
(86) International application number: PCT/US2006/035636
(87) International publication number: WO 2007/033240

(56) References cited:
- WO-A-98/10303
- WO-A-02/084624
- US-A1- 2003 065 267
- LADD M E ET AL: "Reduction of resonant RF heating in intravascular catheters using coaxial chokes" MAGNETIC RESONANCE IN MEDICINE, ACADEMIC PRESS, DULUTH, MN, US, vol. 43, no. 4, 2000, pages 615-619, XP002260399 ISSN: 0740-3194 cited in the application
- KONINGS M K ET AL: "CHATHETERS AND GUIDEWIRES IN INTERVENTIONAL MRI: PROBLEMS AND SOLUTIONS" MEDICA MUNDI, PHILIPS MEDICAL SYSTEMS, SHELTON, CT,, US, vol. 45, no. 1, March 2001 (2001-03), pages 31,34-39, XP001079787 ISSN: 0025-7664
- KONINGS M K ET AL: "Heating around intravascular guidewires by resonating RF waves" JOURNAL OF MAGNETIC RESONANCE IMAGING 2000 UNITED STATES, vol. 12, no. 1, 2000, pages 79-85, XP002413489 ISSN: 1053-1807

## Description

### BACKGROUND

### 1. Field of Invention

The present invention relates to a device for use with magnetic resonance imaging (MRI) and more particularly to active MRI compatible and visible interventional and/or intraoperative MRI catheters).

### 2. Discussion of Related Art

Magnetic resonance imaging (MRI) is a well-established medical imaging and diagnostic tool. A great deal of current activity and research relates to interventional and/or intraoperative procedures conducted under MRI guidance (iMRI). A recent summary is provided in "Interventional and Intraoperative MRI at Low Field Scanner - A Review", R. Blanco et al., European Journal of Radiology (preprint, March 8, 2005).

In many interventional and intraoperative procedures under MRI guidance surgical tools such as long needles, guide wires and catheters are used and it is advantageous to a surgeon to be able to image and locate such instruments in conjunction with the magnetic resonance image. To achieve such tracing, interventional devices have been provided with a radio frequency (RF) antenna, more particularly an RF coil, in the device. See for example, U.S. Patent Nos. 5,271,400; 5,318,025 and 5,916,162.

The RF coil receives a signal from the sample at the distal end of the catheter or other device and sends an electrical signal directly to the MRI scanner by way of an attached coaxial cable. The coaxial cable is typically a very thin coaxial cable that runs through a lumen in the catheter. The presence of long conductive objects such as the coaxial cable have been found to lead to heating at the tip of the device. Medical studies indicate that this effect is due to coupling of the RF field from the MRI system, primarily to the long cable ("Reduction of Resonant RF Heating in Intravascular Catheters Using Coaxial Chokes ", Mark E. Ladd et al., Magnetic Resonance in Medicine 43:615-619 (2000); "RF Safety of Wires in Interventional MRI: Using a Safety Index", Christopher J. YEUNG et al., Magnetic Resonance in Medicine 47:187-193 (2002); *"*RF Heating Due to Conductive Wires During MRI Depends on the Phase Distribution of the Transmit Field ", Christopher J. YEUNG et al., Magnetic Resonance in Medicine 48: 1096-1098 (2002); and *"*Safety of MRI-Guided Endovascular Guidewire Applications", Chia-Ying LIU et al., Journal of Magnetic Resonance Imaging 12:75-78 (2000)). These studies indicate that long cables, even without the RF coil, show significant heating, whereas, RF coils without the cable show no heating.

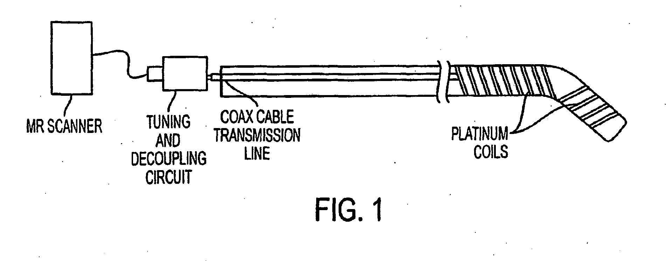

Long transmission lines, i.e., longer than one quarter of the RF wavelength within the body (approximately 80 cm), couples significantly with the RF transmission energy of the body coil of the MRI system. Decoupling circuits have been used at the proximal end of the catheter to reduce the electric field coupling, but this approach does not work well when the conductor exceeds 80 cm (see Figure 1). Because of this heating problem, active MRI compatible and visible catheters are currently used only in animal studies. Consequently, there is a need for improved active MRI compatible devices that do not have a severe heating problem.

### SUMMARY

It is thus an object of the current invention to provide improved devices for use with magnetic resonance imaging.

A catheter for use with magnetic resonance imaging comprising: a catheter body (102); a radio frequency antenna (104) disposed in a distal end of said catheter body (102); characterized in that a first ultrasonic transducer (106) being electrically connected to said radio frequency antenna is disposed in said distal end of said catheter body; in that the catheter further comprises a second ultrasonic transducer (110) disposed in a proximal end of said catheter body (102) and an acoustic waveguide (108) disposed in said catheter body (102) extending from said distal end to said proximal end of said catheter body, said acoustic waveguide being acoustically matched to said first ultrasonic transducer, and in that the catheter is arranged to convert radio frequency signals received by said radio frequency antenna (104), to corresponding acoustic signals using said first ultrasonic transducer (106), to transmit said converted signals acoustically using said acoustic waveguide (108), and to convert said acoustic signals to electrical signals using said second ultrasonic transducer (110).

Further objectives and advantages will become apparent from a consideration of the detailed description, drawings, and examples.

### BRIEF DESCRIPTION OF THE DRAWINGS

The invention may be better understood by reading the following detailed description with reference to the accompanying figures, in which like reference numerals refer to like elements throughout, and in which:
Figure 1 is an illustration of a conventional iMRI catheter that has RF coils, a long coaxial transmission cable and a decoupling circuit.
Figure 2 is a schematic illustration of an example of a catheter for use with magnetic resonance imaging according to an embodiment of this invention.
Figure 3 is an enlarged view of the distal end of the catheter of Figure 2.
Figures 4 and 5 schematically illustrate an ultrasonic transducer for use in the current invention in a state without an applied voltage (Figure 4) and with an applied voltage (Figure 5).
Figure 6 is an enlarged view of the proximal end of the catheter of Figure 2.
Figure 7 is a schematic illustration of an example of a device which is not an embodiment of this invention.

### DETAILED DESCRIPTION

In describing particular embodiments and examples of the present invention illustrated in the drawings, specific terminology is employed for the sake of clarity. However, the invention is not intended to be limited to the specific terminology so selected. It is to be understood that each specific element includes all technical equivalents which operate in a similar manner to accomplish a similar purpose.

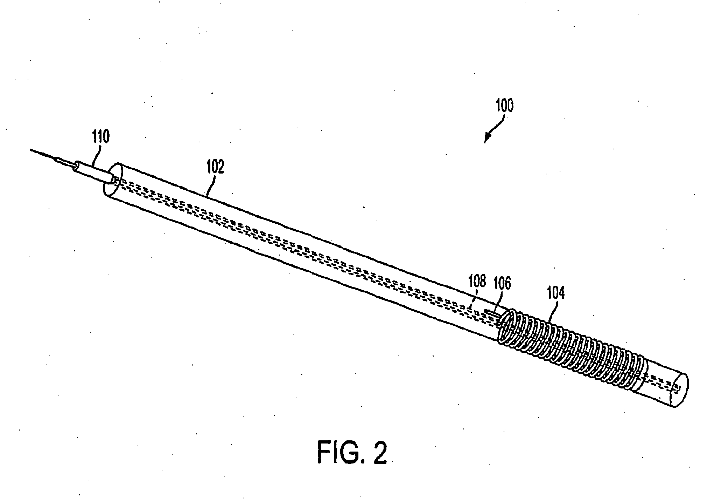

Figure 2 is a schematic illustration of a catheter 100 for use with magnetic resonance imaging according to an embodiment of this invention. The catheter body 102 has at least one lumen extending along the length of the catheter 100. A radio frequency antenna 104 is disposed in a distal end of the catheter body 102. A first ultrasonic transducer 106 is also disposed in a distal end of a catheter body 102 and is electrically connected to the radio frequency antenna 104. An acoustic waveguide 108 is disposed in a catheter body 102 and extends from a distal to a proximal end of the catheter body. The acoustic waveguide 108 is acoustically matched to the first ultrasonic transducer 106. A second ultrasonic transducer 110 is disposed in the proximal end of the catheter body 102 of a catheter 100 for use with magnetic resonance imaging. The second ultrasonic transducer 110 is also acoustically matched to the acoustic wave guide 108.

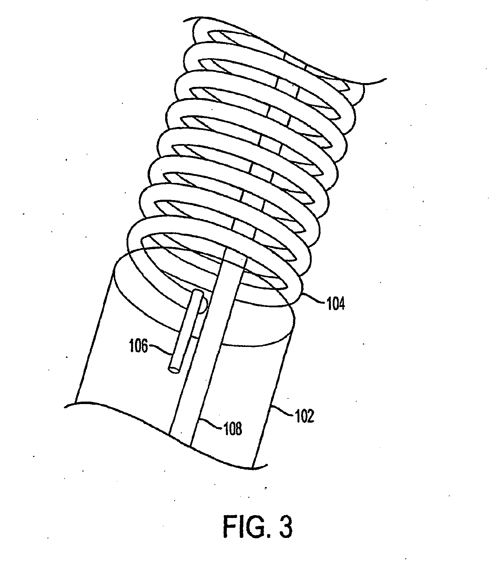

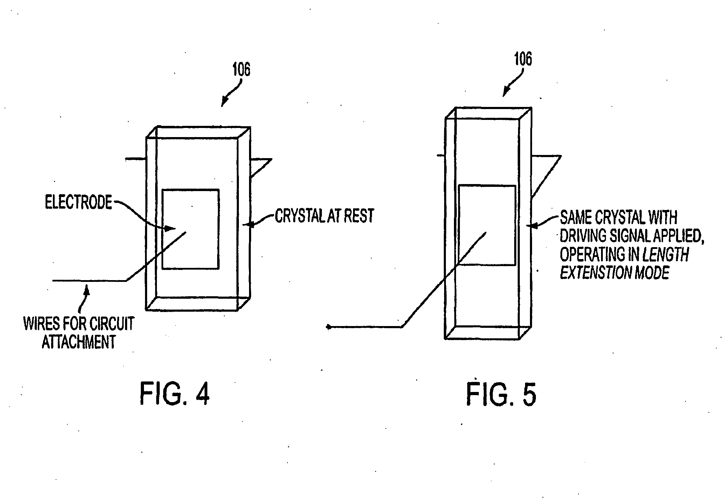

Figure 3 is an enlarged view if the distal end of the catheter 100 for use with magnetic resonance imaging. In this embodiment, the radio frequency antenna 104 is a radio frequency coil. Platinum-iridium, insulated copper and insulated gold are all suitable materials for the RF antenna 104. In this embodiment, the first ultrasonic transducer 106 is a micro-electromechanical system (MEMS) ultrasonic transducer. The active element of this MEMS ultrasonic transducer is a piece of polarizable material with electrodes attached to two opposing faces (see Figures 4 and 5). When an electric field is applied across the material, polarized molecules of the material will align with the applied electric field, resulting in induced dipoles within the molecular or crystalline structure of the material. This alignment causes the dimensions of the MEMS transducer to change. The frequency of these transformed sound waves can be determined by the crystal membrane material, thickness and cutting direction. MEMS ultrasonic transducers that produce 40 MHz sound waves have been found to be suitable. However, the general concepts of the invention are not limited to the specific frequency chosen for a specific application. Ultrasonic transducers that operate at 10 MHz have also been used to practice this invention.

In the current embodiment, the acoustic waveguide 108 is acoustically matched to the acoustic frequency of the ultrasonic transducer 106. Since it is often desirable to have a flexible catheter, one should then select a flexible acoustic waveguide 108. However, the general concepts of the invention are not limited to only flexible acoustic waveguides. To obtain proper acoustic coupling with currently available ultrasonic transducers, optical fibers having about a 3:1 clad to core ratio have been found to be suitable. Furthermore, the core of the waveguide is doped with titanium oxide, or B₂O₃ or is fused silica to reduce attenuation during transmission in this embodiment of the invention. A core doped with about 7.5% titanium oxide has been found to be suitable in particular applications. A core of the acoustic waveguide doped with about 5% of B₂O₃ has been found to be suitable in particular applications. Although specific examples of waveguides are described here, the general concepts of the embodiment include any acoustic waveguides that can provide a means to transmit the acoustic signal.

In addition to being desirable to have a flexible acoustic waveguide for certain applications, it is typically desirable for catheters to be very narrow. Since many catheters may include two or more lumens in order to carry out multiple functions, for example, being threaded over a guide wire, and/or injecting or removing material from the distal end of the catheter, one may wish for the acoustic waveguide to be very narrow. Good results have been achieved with an optical fiber waveguide as thin as about 600 µm.

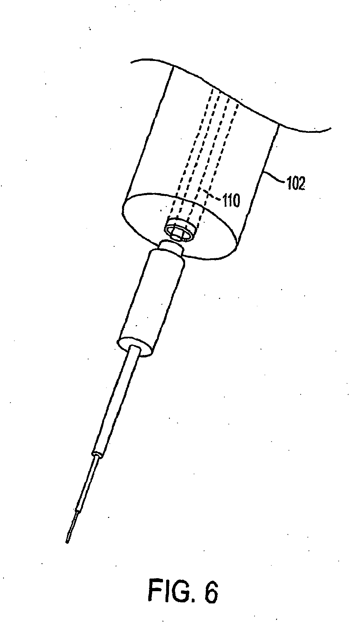

The second ultrasonic transducer 110 may be similar to or substantially the same as the first ultrasonic transducer 106 and is similarly coupled to the optical waveguide 108. Figure 6 illustrates a more detailed view of the proximal end of a catheter 100 according to this embodiment of the invention. The ultrasonic transducer 110 has electrical leads that connect to electrical components outside of the catheter 100 (not shown).

In operation, the catheter 100 is used in combination with a magnetic resonance imaging system. The MRI system may be any of a variety of MRI systems available which generally provide a strong magnetic field across the body under observation. The body coil of the MRI system provides RF radiation appropriate to cause protons within the sample to precess at the Larmor frequency. After removal of the RF excitation energy, precessing protons, i.e., hydrogen nuclei, make a transition back to the lower energy state, thus reemitting electromagnetic energy at the RF wavelength. In addition to the MRI system generating a magnetic resonance image in the usual way, the RF coil 104 also receives local RF radiation emitted from the body under observation. The RF radiation received by the coil 104 drives the ultrasonic transducer 106 to generate an acoustic signal. The acoustic signal from the ultrasonic transducer 106 is coupled into the acoustic waveguide 108 and transmitted along the length of the catheter 100 to reach the second ultrasonic transducer 110. The second ultrasonic transducer now operates in the reverse sense from a first ultrasonic transducer in that it is driven by the ultrasonic waves from the acoustic waveguide 108 to thereby generate an electrical signal that is output from the ultrasonic transducer 110. The electrical signals output from the ultrasonic transducer 110 are then directed to external electronic components that can then process and combine them in an appropriate way with the MRI image.

This procedure describes using the catheter 100 in a receive mode. However, the catheter 100 could also be used in a transmit mode. In a transmit mode, the electrical signals are applied to the second ultrasonic transducer 110 to generate an acoustic signal that is coupled into the acoustic waveguide 108. The acoustic signal is transmitted along the acoustic waveguide 108 to the first ultrasonic transducer 106 which is driven by the acoustic signal to generate an electrical signal. The electrical signal, output from the first ultrasonic transducer 106 is directed to the RF coil 104 which produces RF electromagnetic radiation. Typically, this RF radiation will be of much lower strength than one could generate with the external device of the MRI system. Consequently, many applications will use the catheter 100 in a receive mode only. However, the general concepts of the invention include the use of the catheter in receive and/or transmit modes.

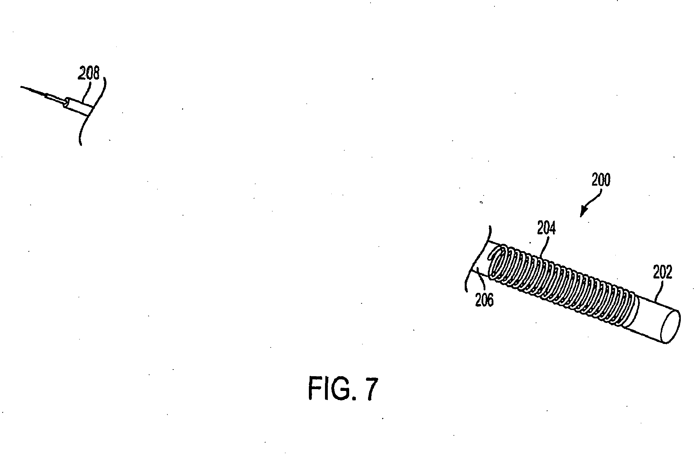

In anotherexample (which, however, is no embodiment of the invention) as illustrated schematically in Figure 7 for one example, an insertable device 200 has a device body 202 having a radio frequency antenna 204 and a first ultrasonic transducer 206 disposed therein. A second ultrasonic transducer 208 of the device according to this example is arranged in contact with a surface of the body under observation or otherwise in contact with the body in a way that electrical leads can exit away from the body under observation to external electrical components of the MRI system.

In this example, the RF antenna 204 may also be an RF coil as in the first embodiment of this invention. The RF coil 204 may also be constructed from platinum-iridium, insulated copper or insulated gold. The ultrasonic transducers 206 and 208 may be similar to the ultrasonic transducers 106 and 110, but will generally require stricter manufacturing standards than are required for a case in which an acoustic waveguide is used. The ultrasonic transducers 206 and 208 are selected from high quality ultrasonic transducers that are typically now only produced in high precision laboratory conditions.

In this embodiment of the invention, the RF coil 204 picks up an RF signal from the body under observation and the electrical signal from the RF coil 204 drives the ultrasonic transducer 206. The ultrasonic transducer 206 transmits an ultrasonic signal through a portion of the body under observation until it reaches ultrasonic transducer 208 on the surface, or in the surface region, of the body under observation. The ultrasonic transducer 208 receives acoustic signals transmitted by the ultrasonic transducer 206 and converts them into electrical signals that are then directed to external electrical components, such as the electronics of the MRI system.

Similar to the embodiment illustrated in Figure 2, this configuration may be used in either receive and/or transmit modes. In the transmit mode, the ultrasonic transducer 208 receives electrical signals through wires in contact with electrodes of the ultrasonic transducer 208. The electrical signals drive the ultrasonic transducer 208 to produce an ultrasonic signal that is transmitted through a portion of a body under observation to be received by ultrasonic transducer 206. The acoustic signal received by the ultrasonic transducer 206 is converted into an electrical signal which is directed to RF coil 204 which produces an RF signal corresponding to the Larmor frequency.

Although this invention has been described in terms of particular examples of embodiments of the invention, one of ordinary skill in the art should recognize from the teachings herein that many modifications and alternatives to these examples are possible within the scope of this invention. All such modifications and alternatives are intended to be covered by the current invention, as defined by the claims.

## Claims

1. A catheter for use with magnetic resonance imaging, comprising:
a catheter body (102);
a radio frequency antenna (104) disposed in a distal end of said catheter body (102);
**characterized in that**
a first ultrasonic transducer (106) being electrically connected to said radio frequency antenna is disposed in said distal end of said catheter body;
**in that** the catheter further comprises a second ultrasonic transducer (110) disposed in a proximal end of said catheter body (102) and an acoustic waveguide (108) disposed in said catheter body (102) extending from said distal end to said proximal end of said catheter body, said acoustic waveguide being acoustically matched to said first ultrasonic transducer, and
**in that** the catheter is arranged to convert radio frequency signals received by said radio frequency antenna (104), to corresponding acoustic signals using said first ultrasonic transducer (106), to transmit said converted signals acoustically using said acoustic waveguide (108), and to convert said acoustic signals to electrical signals using said second ultrasonic transducer (110).

2. A catheter for use with magnetic resonance imaging according to claim 1, wherein the catheter is arranged to convert electrical signals to acoustic signals using said second ultrasonic transducer (110), to transmit said acoustic signals along said acoustic waveguide (108), to convert said acoustic signals to electrical signals, using said first ultrasonic transducer (106) and to convert said electrical signals to radio frequency illumination signals using said radio frequency antenna (104).

3. A catheter for use with magnetic resonance imaging according to claim 1 or claim 2, wherein said acoustic waveguide (108) is an optical fiber.

4. A catheter for use with magnetic resonance imaging according to claim 3, wherein said optical fiber has a cladding-to-core ratio of about 3:1.

5. A catheter for use with magnetic resonance imaging according to claim 3 or claim 4, wherein said optical fiber has a fused silica core.

6. A catheter for use with magnetic resonance imaging according to claim 3 or claim 4, wherein said optical fiber has a core doped with titanium oxide.

7. A catheter for use with magnetic resonance imaging according to claim 6, wherein said core is doped with about 7.5% titanium oxide.

8. A catheter for use with magnetic resonance imaging according to claim 3 or claim 4, wherein said optical fiber has a core doped with B₂O₃.

9. A catheter for use with magnetic resonance imaging according to claim 8, wherein said core of said optical fiber is doped with about 5% B₂O₃⁻

10. A catheter for use with magnetic resonance imaging according to any one of claims 3 to 9, wherein said optical fiber has an outer diameter of about 600 µm.

11. A catheter for use with magnetic resonance imaging according to any one of the preceding claims, wherein said radio frequency antenna (104) is a coil antenna.

12. A catheter for use with magnetic resonance imaging according to claim 11, wherein said coil antenna is made from at least one of platinum-iridium, insulated copper and insulated gold.

## Patentansprüche

1. Ein Katheter zur Verwendung mit Magnetresonanzbildgebung, mit:
einem Katheterkörper (102);
einer Radiofrequenzantenne (104), angeordnet in einem distalen Ende des Katheterkörpers (102), **dadurch gekennzeichnet, dass**
ein erster Ultraschallwandler (106), der elektrisch mit der Radiofrequenzantenne verbunden ist, in dem distalen Ende des Katheterkörpers angeordnet ist;
dass der Katheter weiter einen zweiten Ultraschallwandler (110) umfasst, welcher angeordnet ist in einem proximalen Ende des Katheterkörpers (102) und einen akustischen Wellenleiter (108), welcher angeordnet ist in dem Katheterkörper (102), der sich von dem distalen Ende zu dem proximalen Ende des Katheterkörpers erstreckt, wobei der akustische Wellenleiter akustisch an den ersten Ultraschallwandler angepasst ist, und
dass der Katheter angeordnet ist, um Radiofrequenzsignale, welche von der Radiofrequenzantenne (104) empfangen werden, unter Verwendung des ersten Ultraschallwandlers (106) in entsprechende akustische Signale umzuwandeln, um die umgewandelten Signale akustisch unter Verwendung des akustischen Wellenleiters (108) zu übertragen und um die akustischen Signale unter Verwendung des zweiten Ultraschallwandlers (110) in elektrische Signale umzuwandeln.

2. Ein Katheter zur Verwendung mit Magnetresonanzbildgebung gemäß Anspruch 1, wobei der Katheter angeordnet ist, um elektrische Signale unter Verwendung des zweiten Ultraschallwandlers (110) in akustische Signale umzuwandeln, um die akustischen Signale entlang des akustischen Wellenleiters (108) zu übertragen, um die akustischen Signale unter Verwendung des ersten Ultraschallwandlers (106) in elektrische Signale umzuwandeln und um die elektrischen Signale unter Verwendung der Radiofrequenzantenne (104) zu Radiofrequenzbestrahlungssignalen umzuwandeln.

3. Ein Katheter zur Verwendung mit Magnetresonanzbildgebung gemäß Anspruch 1 oder Anspruch 2, wobei der akustische Wellenleiter (108) eine optische Faser ist.

4. Ein Katheter zur Verwendung mit Magnetresonanzbildgebung gemäß Anspruch 3, wobei die optische Faser ein Mantel-Kern-Verhältnis (cladding-to-core ratio) von etwa 3:1 aufweist.

5. Ein Katheter zur Verwendung mit Magnetresonanzbildgebung gemäß Anspruch 3 oder Anspruch 4, wobei die optische Faser einen Quarzglaskern aufweist.

6. Ein Katheter zur Verwendung mit Magnetresonanzbildgebung gemäß Anspruch 3 oder Anspruch 4, wobei die optische Faser einen Kern aufweist, der mit Titanoxid dotiert ist.

7. Ein Katheter zur Verwendung mit Magnetresonanzbildgebung gemäß Anspruch 6, wobei der Kern mit etwa 7,5 % Titanoxid dotiert ist.

8. Ein Katheter zur Verwendung mit Magnetresonanzbildgebung gemäß Anspruch 3 oder Anspruch 4, wobei die optische Faser einen Kern aufweist, der mit B₂O₃ dotiert ist.

9. Ein Katheter zur Verwendung mit Magnetresonanzbildgebung gemäß Anspruch 8, wobei der Kern der optischen Faser mit etwa 5 % B₂O₃ dotiert ist.

10. Ein Katheter zur Verwendung mit Magnetresonanzbildgebung gemäß irgendeinem der Ansprüche 3 bis 9, wobei die optische Faser einen äußeren Durchmesser von etwa 600 µm aufweist.

11. Ein Katheter zur Verwendung mit Magnetresonanzbildgebung gemäß irgendeinem der vorhergehenden Ansprüche, wobei die Radiofrequenzantenne (104) eine Spulenantenne ist.

12. Ein Katheter zur Verwendung mit Magnetresonanzbildgebung nach Anspruch 11, wobei die Spulenantenne hergestellt ist aus wenigstens einem aus: Platin-Iridium, isoliertem Kupfer und isoliertem Gold.

## Revendications

1. Cathéter pour imagerie par résonance magnétique, comprenant:
un corps de cathéter (102) ;
une antenne radiofréquence (104) disposée dans une extrémité distale dudit corps de cathéter (102);
**caractérisé en ce que**
un premier transducteur ultrasonore (106) connecté électriquement à ladite antenne radiofréquence est disposé dans ladite extrémité distale dudit corps de cathéter;
**en ce que** le cathéter comprend en outre un second transducteur ultrasonore (110) disposé dans une extrémité proximale dudit corps de cathéter (102) et un guide d'onde acoustique (108) disposé dans ledit corps de cathéter (102) s'étendant de ladite extrémité distale à ladite extrémité proximale dudit corps de cathéter, ledit guide d'onde acoustique étant adapté acoustiquement audit premier transducteur ultrasonore, et
**en ce que** le cathéter est conçu pour convertir les signaux radiofréquence reçus par ladite antenne radiofréquence (104) en signaux acoustiques correspondants en utilisant ledit premier transducteur ultrasonore (106), pour transmettre lesdits signaux convertis acoustiquement en utilisant ledit guide d'onde acoustique (108), et pour convertir lesdits signaux acoustiques en signaux électriques en utilisant ledit second transducteur ultrasonore (110).

2. Cathéter pour imagerie par résonance magnétique selon la revendication 1, dans lequel le cathéter est conçu pour convertir des signaux électriques en signaux acoustiques en utilisant ledit second transducteur ultrasonore (110), pour transmettre lesdits signaux acoustiques le long dudit guide d'onde acoustique (108), pour convertir lesdits signaux acoustiques en signaux électriques, en utilisant ledit premier transducteur ultrasonore (106) et pour convertir lesdits signaux électriques en signaux d'éclairage radiofréquence en utilisant ladite antenne radiofréquence (104).

3. Cathéter pour imagerie par résonance magnétique selon la revendication 1 ou la revendication 2, dans lequel ledit guide d'onde acoustique (108) est une fibre optique.

4. Cathéter pour imagerie par résonance magnétique selon la revendication 3, dans lequel ladite fibre optique a un rapport gaine/coeur d'environ 3:1.

5. Cathéter pour imagerie par résonance magnétique selon la revendication 3 ou la revendication 4, dans lequel ladite fibre optique a un coeur de silice fondue.

6. Cathéter pour imagerie par résonance magnétique selon la revendication 3 ou la revendication 4, dans lequel ladite fibre optique a un coeur dopé avec de l'oxyde de titane.

7. Cathéter pour imagerie par résonance magnétique selon la revendication 6, dans lequel ledit coeur est dopé avec environ 7,5 % d'oxyde de titane.

8. Cathéter pour imagerie par résonance magnétique selon la revendication 3 ou la revendication 4, dans lequel ladite fibre optique a un coeur dopé avec du B₂O₃.

9. Cathéter pour imagerie par résonance magnétique selon la revendication 8, dans lequel ledit coeur de ladite fibre optique est dopé avec environ 5 % de B₂O₃.

10. Cathéter pour imagerie par résonance magnétique selon l'une quelconque des revendications 3 à 9, dans lequel ladite fibre optique a un diamètre externe d'environ 600 µm.

11. Cathéter pour imagerie par résonance magnétique selon l'une quelconque des revendications précédentes, dans lequel ladite antenne radiofréquence (104) est une antenne à bobine.

12. Cathéter pour imagerie par résonance magnétique selon la revendication 11, dans lequel ladite antenne à bobine est constituée d'au moins un du platine-iridium, du cuivre isolé et de l'or isolé.
